(19) Europäisches Patentamt
European Patent Office
Office européen des brevets

(11) **EP 4 071 678 A1**

(12) **EUROPÄISCHE PATENTANMELDUNG**

(43) Veröffentlichungstag:
**12.10.2022 Patentblatt 2022/41**

(21) Anmeldenummer: **21166905.6**

(22) Anmeldetag: **06.04.2021**

(51) Internationale Patentklassifikation (IPC):
***G06Q 10/00*** *(2012.01)*

(52) Gemeinsame Patentklassifikation (CPC):
**G06Q 10/30; G06Q 50/04**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **FRANKE, Martin**
**14089 Berlin (DE)**
• **TAUCHER, Herbert**
**1190 Wien (AT)**
• **WOLFRUM, Philipp**
**81539 München (DE)**

(54) **VORRICHTUNG MIT DIGITALEM ZWILLING EINES ELEKTRONISCHEN BAUTEILS, VERFAHREN ZUM ERZEUGEN DER VORRICHTUNG MIT DIGITALEM ZWILLING, VERFAHREN ZUM BESTIMMEN EINES WIEDERAUFARBEITUNGS-PROZESSES DES BAUTEILS UND VERFAHREN ZUM WIEDERAUFARBEITEN DES ELEKTRONISCHEN BAUTEILS**

(57) Die Erfindung betrifft eine Vorrichtung mit digitalem Zwilling eines elektronischen Bauteils. Die Vorrichtung weist mindestens ein Daten-Medium mit Wiederaufarbeitungs-Daten des Bauteils und mindestens einen Prozessor zum Verarbeiten der Wiederaufbereitungs-Daten auf. Die Wiederaufbereitungs-Daten können aktuelle Wiederaufbereitungs-Daten umfassen. Damit ist es möglich, eine spezifische, relevante Rahmenbedingung (z.B. Gesetzgebung, Rohstoff-Preise, etc.) beachtenden Recycling-(Wiederaufarbeitungs-)Prozess zu bestimmen. Aus ökologischen und aus ökonomischen Gesichtspunkten kann die Wiederaufarbeitung des elektronischen Bauteils optimiert durchgeführt werden.

FIG 1

EP 4 071 678 A1

**Beschreibung**

Die Erfindung betrifft eine Vorrichtung mit digitalem Zwilling eines elektronischen Bauteils (Baugruppe), ein Verfahren zum Erzeugen der Vorrichtung mit digitalem Zwilling und ein Verfahren zum Bestimmen eines Wiederaufbereitungs-Prozesses des Bauteils unter Verwendung des digitalen Zwillings. Darüber hinaus wird ein Verfahren zum Wiederaufarbeiten des elektronischen Bauteils angegeben.

Ein Wiederaufarbeiten (Wiederaufbereiten, Recycling) von elektronischen Bauteilen kann aus ökologischen und aus ökonomischen Gründen sinnvoll sein. Dabei spielen u.a. der Wert (Preis) und die Toxizität der im Bauteil verarbeiteten Materialien eine entscheidende Rolle.

Nach dem Stand der Technik wird Elektronik bzw. werden elektronische Bauteile meist geschreddert und weiter thermisch und chemisch behandelt, so dass einzelne Materialen (z.B. Metalle) rückgewonnen werden können. Eine Zerlegung in einzelne Komponenten (Elektronik- bzw. Bauteil-Komponenten) ohne mechanische Zerstörung wird meist nicht durchgeführt. In Folge davon geht ein Großteil der Materialien verloren.

Aufgabe der vorliegenden Erfindung ist es, aufzuzeigen, wie ein elektronisches Bauteil effizient wiederaufgearbeitet werden kann.

Zur Lösung der Aufgabe wird eine Vorrichtung mit digitalem Zwilling eines elektronischen Bauteils angegeben, wobei die Vorrichtung mindestens ein Daten-Medium mit Wiederaufarbeitungs-Daten des Bauteils und mindestens einen Prozessor zum Verarbeiten der Wiederaufbereitungs-Daten aufweist.

Zur Lösung der Aufgabe wird auch ein Verfahren zum Erzeugen einer Vorrichtung mit digitalem Zwilling angegeben, wobei die Wiederaufbereitungs-Daten bereitgestellt werden.

Der digitale Zwilling (digitaler Doppelgänger, digital twin) des elektronischen Bauteils ist eine digitale Repräsentanz bzw. eine digitale Abbildung des elektronischen Bauteils. Das elektronische Bauteil kann dabei komplex sein, d.h. das elektronische Bauteil ist aus mehreren Bauteil-Komponenten aufgebaut. Es weist mehrere Bauteil-Komponenten auf.

Darüber hinaus wird zur Lösung der Aufgabe ein Verfahren zum Bestimmen eines Wiederaufarbeitungs-Prozesses eines elektronischen Bauteils unter Verwendung der Vorrichtung mit dem digitalen Zwilling angegeben, wobei folgende Arbeitsschritte durchgeführt werden:

> a) Analysieren der Wiederaufbereitungs-Daten des Daten-Mediums und
> b) Bestimmen des Wiederaufarbeitungs-Prozesses (4002) unter Verwendung der Analyse, wobei das Analysieren der Wiederaufbereitungs-Daten und/oder das Bestimmen des Wiederaufbereitungs-Prozesses mit Hilfe des Prozessors durchgeführt werden.

Gemäß einem weiteren Aspekt der Erfindung wird ein Verfahren zum Wiederaufarbeiten eines elektronischen Bauteils angegeben, wobei folgende Arbeits-Schritte durchgeführt werden:

> a') Auswählen des Wiederaufarbeitungs-Prozesses mit Hilfe der Vorrichtung mit digitalem Zwilling und
> b') Durchführen des Wiederaufarbeitungs-Prozesses.

Das Daten-Medium dient als Daten-Quelle für die Wiederaufarbeitungs-Daten. Mit der Daten-Quelle werden die Wiederaufbereitungsdaten bereitgestellt.

Vorzugsweise ist das Daten-Medium ein Daten-Speicher. Die Wiederaufbereitungsdaten werden bzw. sind im Daten-Speicher bleibend hinterlegt.

Die Wiederaufarbeitungs-Daten umfassen Informationen zur Wiederaufarbeitung des elektronischen Bauteils oder zur Wiederaufarbeitung von Bauteil-Komponenten des elektronischen Bauteils.

Mit Hilfe des Prozessors (programmierbares Rechenwerk) können die Wiederaufarbeitungs-Daten des Daten-Mediums ausgelesen und verarbeitet werden.

Die grundlegende Idee der Erfindung besteht darin, einen digitalen Zwilling (digitales Modell) eines elektronischen Bauteils zur Verfügung zu stellen, der Informationen zur Wiederaufarbeitung des Bauteils oder zur Wiederaufarbeitung von Bauteil-Komponenten (Teilen) des elektronischen Bauteils aufweist. Die Wiederaufarbeitungs-Daten können dann zum Wiederaufarbeiten des Bauteils verwendet werden.

Die Wiederaufarbeitungs-Daten können beliebige Informationen umfassen, die für die Wiederaufarbeitung des Bauteils von Bedeutung sind. Gemäß einer besonderen Ausgestaltung weisen die Wiederaufarbeitungs-Daten Informationen zu zumindest einem aus der folgenden Gruppe ausgewählten Gruppen-Mitglied auf:

- Stück-Liste (bill of materials, BOM) des elektronischen Bauteils,
- Arbeits-Schritte zum Herstellen des elektronischen Bauteils,
- Preise (z.B. Einkaufspreise) von Roh-Stoffen, die zur Herstellung des Bauteils verwendet werden,
- mögliche Wiederaufarbeitungs-Verfahren für das elektronische Bauteil und
- gesetzliche Vorgaben für ein Wieder-Aufarbeiten des elektronischen Bauteils.

Dabei kann auch berücksichtigt werden, dass diese Informationen von Land zu Land und/oder zeitlich unterschiedlich sein können. Die Wiederaufarbeitungs-Daten können sich dynamisch ändernde Informationen zu lokalen Gegebenheiten umfassen.

Wie erwähnt, können die Wiederaufarbeitungs-Daten bleibend in einem Daten-Speicher hinterlegt sein.

Insbesondere umfassen die Wiederaufarbeitungs-Daten aber aktuelle Wiederaufarbeitungs-Daten. Vorzugsweise werden also aktuelle Wiederaufarbeitungs-Daten bereitgestellt. Damit die Wiederaufarbeitungs-Daten aktuell (z.B. länder-spezifisch und/oder tages-aktuell) sind, ist die Vorrichtung gemäß einer weiteren Ausgestaltung mit einer Daten-Schnittstelle zum Bereitstellen der Wiederaufarbeitungs-Daten des Daten-Mediums ausgestattet. Über die Daten-Schnittstelle können (zeitlich und örtlich) aktuelle Wiederaufarbeitungs-Daten (drahtlos oder drahtgebunden) eingelesen und damit zur Verarbeitung durch den Prozessor zur Verfügung gestellt werden. So kann auf der Grundlage von tages-aktuellen Preisen der verwendeten Materialien (z.B. Rohstoffpreise der Materialien) der Wiederaufarbeitungs-Prozess für das elektronische Bauteil ausgewählt werden. Auch können so Änderungen in der Gesetzgebung bei der Auswahl des Aufarbeitungs-Prozesses berücksichtigt werden.

Die Vorrichtung mit dem digitalen Zwilling der Vorrichtung kann nach dem Entwerfen des elektronischen Bauteils erzeugt werden, z.B. während eines späteren Produkt-Lebens-Phase des elektronischen Bauteils. Die Wiederaufarbeitungs-Daten werden später (einmalig oder wiederholt) bereitgestellt. Vorteilhafterweise wird der digitale Zwilling der Vorrichtung während eines Entwerfens (Designens) des elektronischen Bauteils erzeugt. Damit ist bereits nach dem Entwerfen eine Wiederaufbereitungs-Strategie für das elektronische Bauteil zugänglich, so dass vorbereitende Maßnahmen zum Wiederaufarbeiten des elektronischen Bauteils aufgenommen werden können.

Insbesondere wird das Verfahren des Wiederaufarbeitungs-Prozesses wiederholt durchgeführt. Damit kann z.B. mit Hilfe des digitalen Zwillings auf das Entwerfen des elektronischen Bauteils Einfluss genommen werden (z.B. in einem iterativen Verfahren, bei dem das Analysieren der Wiederaufarbeitungs-Daten und das Bestimmen des Wiederaufarbeitungs-Prozesses wiederholt durchgeführt werden) .

Im Hinblick auf das Verfahren zum Bestimmen eines Wiederaufarbeitungs-Prozesses wird vorzugsweise ein einziger Aufarbeitungs-Prozess automatisch festgelegt (definiert). Mit dem Verfahren kann aber auch eine Auswahl mehrerer Aufarbeitungs-Prozesse vorgeschlagen werden. Die Auswahl des geeigneten Wiederaufarbeitungs-Prozesses aus der Auswahl kann dann wiederum automatisch oder auch durch einen Operateur händisch erfolgen.

In einer besonderen Ausgestaltung wird zum Analysieren der Wiederaufarbeitungs-Daten zumindest eine aus der folgenden Gruppe ausgewählte Information untersucht:

- Information zur generellen Durchführbarkeit des Wiederaufarbeitens des Bauteils,
- Information zu Aufwand und/oder zu Kosten des Wiederaufarbeitens des Bauteils,
- Information zu gesetzlichen Vorgaben für das Wiederaufarbeiten des Bauteils,
- Information zum Grad der Wiederaufarbeitung des Bauteils,
- Information zu möglichen Wiederaufarbeitungs-Prozessen,
- Information über Kosten der Wiederaufarbeitung des Bauteils und
- Information zum erwartbaren Gewinn durch das Wiederaufarbeiten des Bauteils.

Die Information zur generellen Durchführbarkeit des Aufarbeitens des Bauteils umfasst z.B. Informationen zur Zerlegbarkeit des Bauteils. Information zu gesetzlichen Vorgaben für das Wiederaufarbeiten des Bauteils (oder Bauteil-Komponenten des Bauteils) betreffen insbesondere lokale, aktuelle Gesetze und Rechtsprechung dazu. Beispielsweise sind Grenzen für die Verunreinigung der Umwelt durch das Wiederaufarbeiten des Bauteils gesetzlich geregelt.

Information zu Aufwand und/oder zu Kosten des Wiederaufarbeitens des Bauteils und Informationen zum erwartbaren Gewinn durch das Aufarbeiten beziehen sich auf ökonomische Faktoren des Wiederaufarbeitens bzw. ökonomische Faktoren verschiedener, möglicher (potenzieller) Wiederaufarbeitungs-Prozesse.

In einer besonderen Ausgestaltung wird zum Analysieren der Wiederaufarbeitungs-Daten und/oder zum Bestimmen des Wiederaufarbeitungs-Prozesses mindestens ein mathematisches Optimierungs-Verfahren verwendet.

Zusammenfassend sind mit der Erfindung folgende Vorteile verbunden:

- Mit Hilfe der Erfindung kann ein unter ökonomischen und ökologischen Gesichtspunkten geeigneter (günstiger) Wiederaufarbeitungs-Prozesses ausgewählt werden.

- Die Anwendung fest vorgegebener Standard-Wiederaufarbeitungs-Prozesse kann vermieden werden. Die Erfindung zeichnet sich durch eine hohe Flexibilität aus. Auf gegebene Rahmenbedingungen (z.B. aktuelle Gesetze) und deren Änderungen kann individuell schnell reagiert werden.

- Vorhandene Wiederaufarbeitungs-Ressourcen (Mittel zur Wiederaufarbeitung von Bauteilen) können genutzt werden.

- Bereits beim Entwerfen eines elektronischen Bauteils wird die Wiederaufarbeitung des elektronischen Bauteils berücksichtigt. So können frühzeitig Vorbereitungen für die Wiederaufarbeitung des elektronischen Bauteils getroffen werden.

- Das Entwerfen eines elektronischen Bauteils erfolgt unter ökologischen Geschichtspunkten. Der Notwendigkeit der Nachhaltigkeit beim Entwerfen eines elektronischen Bauteils wird damit Rechnung getragen.

- Neben der Nachhaltigkeit wird die Wirtschaftlichkeit bezüglich möglicher Wiederaufarbeitungs-Prozesse des Bauteils berücksichtigt.

- Bereits beim Entwerfen des elektronischen Bauteils wird seine grundlegende Wiederaufarbeitbarkeit (Recyclebarkeit berücksichtigt.

- Auch kann während des Entwerfens ein konkreter Ablauf der Demontage/des Wiederaufarbeitungs-Prozesses für das elektronische Bauteil bestimmt werden.

- Die Demontierbarkeit und Recyclebarkeit hängen stark vom Aufbau des elektronischen Bauteils ab, der ohne eine genaue Kenntnis des Bauteils nicht ohne Weiteres zu erkennen wäre. Der digitale Zwilling ist ein Modell des elektronischen Bauteils und stellt genau diese Kenntnisse bereit.

- Mithilfe des digitalen Zwillings kann ein elektronisches Bauteil für das jeweilige Design optimiert auseinandergebaut werden, um ein Maximum der enthaltenen Rohstoffe wiederzugewinnen.

Anhand eines Ausführungsbeispiels und der dazugehörigen Figuren wird die Erfindung näher beschrieben. Die Figuren sind schematisch und stellen keine maßstabsgetreuen Abbildungen dar.

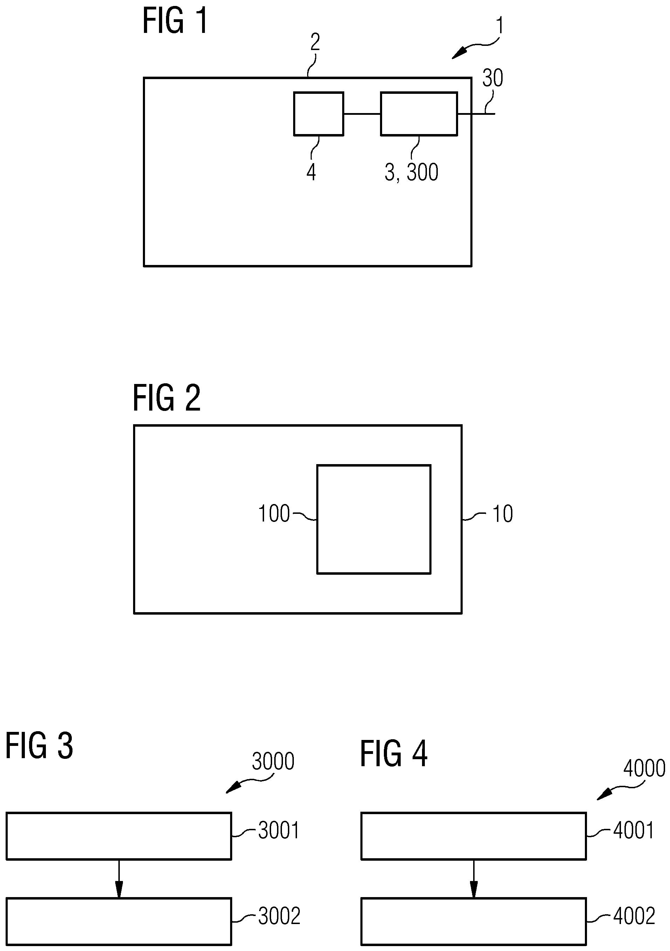

Figur 1 zeigt eine Vorrichtung mit einem digitalen Zwilling.

Figur 2 zeigt ein elektronisches Bauteil.

Figur 3 zeigt ein Verfahren zum Bestimmen eines Wiederaufarbeitungs-Prozesses eines elektronischen Bauteils.

Figur 4 zeigt ein Verfahren zum Wiederaufarbeiten eines elektronischen Bauteils.

Ziel des Ausführungsbeispiel ist es, einen auf das elektronische Bauteil 10 bzw. auf die Bauteil-Komponente 100 des elektronischen Bauteils 10 zugeschnittenen Wiederaufarbeitungs-Prozess zu bestimmen.

Ausgangspunkt dazu ist eine Vorrichtung 1 mit digitalem Zwilling 2 des elektronischen Bauteils 10 bzw. der Bauteil-Komponente 100 des elektronischen Bauteils 10. Die Vorrichtung 1 weist ein Daten-Medium 3 mit Wiederaufarbeitungs-Daten 300 des Bauteils 10 auf. Das Daten-Medium 3 ist ein Daten-Speicher. Die Vorrichtung 1 weist einen Prozessor 4 zum Verarbeiten der Wiederaufbereitungs-Daten 300 auf.

Die Wiederaufarbeitungs-Daten 300 sind aktuelle (tages-aktuelle) Wiederaufbereitungs-Daten, die drahtlos über die Daten-Schnittstelle 30 bereitgestellt werden. Die Wiederaufbereitungs-Daten 300 enthalten folgende Daten:

- Stück-Liste des elektronischen Bauteils 10 auf,
- Arbeits-Schritte zum Herstellen des elektronischen Bauteils 10,
- Preise von Roh-Stoffen, die zur Herstellung des Bauteils 10 verwendet werden,
- mögliche Wiederaufarbeitungs-Verfahren für das elektronische Bauteil 10 und
- gesetzliche Vorgaben für ein Wieder-Aufarbeiten des elektronischen Bauteils 10.

Für die spätere Wiederaufarbeitung des elektronischen Bauteils 10 wird der digitale Zwilling 2 bereits während des Entwerfens des elektronischen Bauteils 10 erzeugt.

Unter Verwendung der Vorrichtung 1 mit dem digitalen Zwilling 2 wird ein Verfahren 3000 zum Bestimmen eines

Wiederaufarbeitungs-Prozesses 4002 für das mit dem digitalen Zwilling 2 abgebildeten elektronischen Bauteils 10 mit folgender Vorgehensweise durchgeführt:

a) Schritt 3001: Analysieren der Wiederaufbereitungs-Daten 300 des Daten-Mediums 3 und
b) Schritt 3002: Bestimmen des Wiederaufarbeitungs-Prozesses 4002 unter Verwendung der Analyse, wobei

das Analysieren 3001 der Wiederaufbereitungs-Daten 300 und/oder das Bestimmen 3002 des Wiederaufbereitungs-Prozesses 4002 mit Hilfe des Prozessors 4 durchgeführt werden.

Der Wiederaufarbeitungs-Prozess wird im Nachhinein auf der Grundlage tages-aktueller Wiederaufbereitungs-Daten bestimmt. In einer alternativen Ausführungsform wird der Wiederaufbereitungs-Prozess bereits während oder nach dem Entwerfen des elektronischen Bauteils 10 bestimmt. Dazu werden dann nicht tages-aktuelle Wiederaufbereitungs-Daten verwendet.

Für den Schritt 3001 (Analysieren der Wiederaufbereitungs-Daten 300 des Daten-Mediums 3) werden folgende Informationen untersucht:

- Information zur generellen Durchführbarkeit des Aufarbeitens des Bauteils 10,
- Information zu Aufwand und/oder zu Kosten des Wiederaufarbeitens des Bauteils 10,
- Information zu gesetzlichen Vorgaben für das Wiederaufarbeiten des Bauteils 10,
- Information zum Grad der Wiederaufarbeitung des Bauteils 10,
- Information zu möglichen Wiederaufarbeitungs-Prozessen für das Bauteil 10,
- Information über Kosten des Wiederaufarbeitens des Bauteils 10 und

- Information zum erwartbaren Gewinn durch das Wiederaufarbeiten des Bauteils 10.

Schließlich wird das elektronische Bauteil 10 mit folgenden Arbeits-Schritten wiederaufgearbeitet:

a') Auswählen (4001) des Wiederaufarbeitungs-Prozesses 4002 mit Hilfe der Vorrichtung 1 mit dem digitalen Zwilling 2 und
b') Durchführen des Wiederaufarbeitungs-Prozesses (4002).

Im Folgenden wird das Auswählen 4001 des Wiederaufbereitungs-Prozesses 4002 des elektronischen Bauteil 10 näher beschrieben.

Für das elektronische Bauteil 10 mit dem Design D und alle berücksichtigten Recycling-Methoden $m_i (i = 1..N)$, werden folgende Funktionen zur Verfügung gestellt:

- Eine boolesche Funktion $R(D,m_i)$, die angibt, ob das elektronische Bauteil 10 mit der Wiederaufarbeitungs-Prozess (Recycling-Methode) $m_i$ technisch zerlegbar ist und dabei alle gesetzlichen Vorgaben (Regularien) eingehalten werden (Kennzeichnung als "1"), oder nicht (Kennzeichnung als "0").

- Eine skalare Funktion $C_{rec}(D,m_i)$, die die Kosten/den Aufwand der Zerlegung mit dem Wiederaufarbeitungs-Prozess $m_i$ angibt. Für $R(D,m_i) = 0$ wird $C_{rec}(D,m_i) = \infty$ definiert. Diese Funktion beinhaltet auch etwaige zusätzliche Kosten, die durch gesetzliche Auflagen für den gewählten Wiederaufarbeitungs-Prozess $m_i$ anfallen.

- Eine ein- oder mehrdimensionale Funktion $V_{rec}(D,m_i)$, die den Recycling-Grad und den Wert der wiedergewonnenen Komponenten und Materialien wiedergibt.

- Eine skalare Funktion $V_{tot,rec}(D,m_i) = f(V_{rec}(D,m_i)) - Crec(D,m_i)$ als Gesamt-Nutzen des Wiederaufarbeitungs-Prozesses $m_i$. Diese aggregiert die ggf. mehrdimensionale Funktion $V_{rec}(D,m_i)$ auf einen skalaren Wert $f(V_{rec}(D,m_i))$, der den Nutzen des Wiederaufarbeitungs-Prozesses $m_i$ darstellt, und zieht davon die Kosten $C_{rec}(D,mi)$ ab. Diese Funktion kann negativ sein, wenn der Wiederaufarbeitungs-Aufwand den Wert der aus dem Wiederaufarbeitungs-Prozess entstehenden Materialien übersteigt.

Des Weiteren wird nun ein mathematisches Optimierungs-Verfahren angewandt, das unter allen Wiederaufbereitungs-Prozessen $m_i$ den auswählt, der den Gesamt-Nutzen maximiert:

$$i = \underset{i=1..N}{\arg\max}\left(V_{tot,rec}(D,m_i)\right)$$

**Patentansprüche**

1. Vorrichtung (1) mit digitalem Zwilling (2) eines elektronischen Bauteils (10), wobei die Vorrichtung (1)

   - mindestens ein Daten-Medium (3) mit Wiederaufarbeitungs-Daten (300) des Bauteils (10) und
   - mindestens einen Prozessor (4) zum Verarbeiten der Wiederaufbereitungs-Daten (300) aufweist.

2. Vorrichtung nach Anspruch 1, wobei das Daten-Medium (3) ein Daten-Speicher ist.

3. Vorrichtung nach Anspruch 1 oder 2, wobei die Wiederaufarbeitungs-Daten (300) Informationen zu zumindest einem aus der folgenden Gruppe ausgewählten Gruppen-Mitglied aufweist:

   - Stück-Liste des elektronischen Bauteils (10),
   - Arbeits-Schritte zum Herstellen des elektronischen Bauteils (10),
   - Preise von Roh-Stoffen, die zur Herstellung des Bauteils (10) verwendet werden,
   - mögliche Wiederaufarbeitungs-Verfahren für das elektronische Bauteil (10) und
   - gesetzliche Vorgaben für ein Wieder-Aufarbeiten des elektronischen Bauteils (10).

4. Vorrichtung nach einem der Ansprüche 1 bis 3, wobei die Wiederaufarbeitungs-Daten (300) aktuelle Wiederaufarbeitungs-Daten umfassen.

5. Vorrichtung nach einem der Ansprüche 1 bis 4, wobei die Vorrichtung einer Daten-Schnittstelle (30) zum Bereitstellen der Wiederaufarbeitungs-Daten (300) des Daten-Mediums ausgestattet ist.

6. Verfahren zum Erzeugen einer Vorrichtung (1) mit digitalem Zwilling (2) nach einem der Ansprüche 1 bis 5, wobei die Wiederaufarbeitungs-Daten (300) bereitgestellt werden.

7. Verfahren nach Anspruch 6, wobei der digitale Zwilling (2) der Vorrichtung (1) während eines Entwerfens des elektronischen Bauteils (10) erzeugt wird.

8. Verfahren (3000) zum Bestimmen eines Wiederaufarbeitungs-Prozesses (4002) eines elektronischen Bauteils (10) unter Verwendung einer Vorrichtung (1) mit digitalem Zwilling (2) nach einem der Ansprüche 1 bis 5, wobei folgende Arbeitsschritte durchgeführt werden:

    a) Analysieren (3001) der Wiederaufbereitungs-Daten (300) des Daten-Mediums (3) und
    b) Bestimmen (3002) des Wiederaufarbeitungs-Prozesses (4002) unter Verwendung der Analyse, wobei

das Analysieren (3001) der Wiederaufbereitungs-Daten (300) und/oder das Bestimmen (3002) des Wiederaufbereitungs-Prozesses (4002) mit Hilfe des Prozessors (4) durchgeführt werden.

9. Verfahren nach Anspruch 8, wobei das Verfahren wiederholt durchgeführt wird.

10. Verfahren nach Anspruch 8 oder 9, wobei das Bestimmen (3002) des Wiederaufarbeitungs-Prozesses (4002) während eines Entwerfens des elektronischen Bauteils (10) erfolgt.

11. Verfahren nach einem der Ansprüche 8 bis 10, wobei zum Analysieren (3001) der Wiederaufarbeitungs-Daten (300) aktuelle Wiederaufarbeitungs-Daten bereitgestellt werden.

12. Verfahren nach einem der Ansprüche 8 bis 11, wobei zum Analysieren der Wiederaufarbeitungs-Daten (300) zumindest eine aus der folgenden Gruppe ausgewählte Information untersucht wird:

    - Information zur generellen Durchführbarkeit des Aufarbeitens des Bauteils (10),
    - Information zu Aufwand und/oder zu Kosten des Wiederaufarbeitens des Bauteils (10),
    - Information zu gesetzlichen Vorgaben für das Wiederaufarbeiten des Bauteils (10),
    - Information zum Grad der Wiederaufarbeitung des Bauteils (10),
    - Information zu möglichen Wiederaufarbeitungs-Prozessen für das Bauteil (10),
    - Information über Kosten des Wiederaufarbeitens des Bauteils (10) und
    - Information zum erwartbaren Gewinn durch das Wiederaufarbeiten des Bauteils (10).

13. Verfahren nach einem der Ansprüche 8 bis 12, wobei zum Analysieren (3001) der Wiederaufarbeitungs-Daten (300) und/oder zum Bestimmen (3002) des Wiederaufarbeitungs-Prozesses (4002) mindestens ein mathematisches Optimierungs-Verfahren verwendet wird.

14. Verfahren zum Wiederaufarbeiten (4000) eines elektronischen Bauteils (10), wobei folgende Arbeits-Schritte durchgeführt werden:

    a') Auswählen (4001) des Wiederaufarbeitungs-Prozesses (4002) mit Hilfe einer Vorrichtung (1) mit digitalem Zwilling (2) nach einem der Ansprüche 1 bis 5 und
    b') Durchführen des Wiederaufarbeitungs-Prozesses (4002).

**FIG 1**

**FIG 2**

**FIG 3**

**FIG 4**

Europäisches
Patentamt

European
Patent Office

Office européen
des brevets

# EUROPÄISCHER RECHERCHENBERICHT

**Nummer der Anmeldung**

EP 21 16 6905

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WANG YANKAI ET AL: "Big data driven Hierarchical Digital Twin Predictive Remanufacturing paradigm: Architecture, control mechanism, application scenario and benefits", JOURNAL OF CLEANER PRODUCTION, ELSEVIER, AMSTERDAM, NL, Bd. 248, 18. November 2019 (2019-11-18), XP085984332, ISSN: 0959-6526, DOI: 10.1016/J.JCLEPRO.2019.119299 [gefunden am 2019-11-18] * Seite 1 - Seite 2 * * Seite 4 - Seite 12 * ----- | 1-14 | INV. G06Q10/00 |
| A | Bernard Marr: "What Is Digital Twin Technology - And Why Is It So Important?", , 6. März 2017 (2017-03-06), XP055694915, Gefunden im Internet: URL:https://www.forbes.com/sites/bernardmarr/2017/03/06/what-is-digital-twin-technology-and-why-is-it-so-important/#45af33e82e2a [gefunden am 2020-05-13] * das ganze Dokument * ----- | 1-14 | |
| | -/-- | | RECHERCHIERTE SACHGEBIETE (IPC) G06Q |

Der vorliegende Recherchenbericht wurde für alle Patentansprüche erstellt

| Recherchenort | Abschlußdatum der Recherche | Prüfer |
|---|---|---|
| München | 8. September 2021 | Bauer, Rodolphe |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes Dokument

EPO FORM 1503 03.82 (P04C03)

Seite 1 von 2

Europäisches Patentamt
European Patent Office
Office européen des brevets

**EUROPÄISCHER RECHERCHENBERICHT**

Nummer der Anmeldung

EP 21 16 6905

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | Moder Patrick ET AL: "A Holistic Digital Twin Based on Semantic Web Technologies to Accelerate Digitalization" In: "International Conference on Future Information Technology; International Conference on Multimedia and Ubiquitous Engineering; FutureTech 2017, MUE 2017: Advanced Multimedia and Ubiquitous Engineering; May 22-24, 2017 in Seoul, South Korea; IN: Lecture Notes in Electrical Engineering; ISSN 1876-1100", 1. Januar 2020 (2020-01-01), Springer Netherlands, NL, XP055837375, ISSN: 1876-1100 ISBN: 978-94-017-8798-7 Bd. 670, Seiten 3-13, DOI: 10.1007/978-3-030-48602-0_1, Gefunden im Internet: URL:https://link.springer.com/content/pdf/10.1007/978-3-030-48602-0_1.pdf> * Zusammenfassung * * Seiten 6-10 * ----- | 1-14 | |
| | | | RECHERCHIERTE SACHGEBIETE (IPC) |
| A | EP 3 667 578 A1 (SIEMENS AG [DE]) 17. Juni 2020 (2020-06-17) * Zusammenfassung; Abbildung 4 * * Absätze [0008] - [0013], [0015] - [0028] * ----- | 1-14 | |
| A | US 2019/137982 A1 (DE RAHUL [IN] ET AL) 9. Mai 2019 (2019-05-09) * Zusammenfassung; Abbildungen 2,4,5 * * Absätze [0044] - [0046] * * Absätze [0052], [0055] - [0057], [0061] - [0063], [0065] * * Absätze [0075], [0079], [0085], [0087] - [0101] * ----- | 1-14 | |

Der vorliegende Recherchenbericht wurde für alle Patentansprüche erstellt

| Recherchenort | Abschlußdatum der Recherche | Prüfer |
|---|---|---|
| München | 8. September 2021 | Bauer, Rodolphe |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

Seite 2 von 2

**ANHANG ZUM EUROPÄISCHEN RECHERCHENBERICHT
ÜBER DIE EUROPÄISCHE PATENTANMELDUNG NR.**

EP 21 16 6905

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-09-2021

| Im Recherchenbericht angeführtes Patentdokument | Datum der Veröffentlichung | Mitglied(er) der Patentfamilie | Datum der Veröffentlichung |
|---|---|---|---|
| EP 3667578 A1 | 17-06-2020 | KEINE | |
| US 2019137982 A1 | 09-05-2019 | KEINE | |

EPO FORM P0461

Für nähere Einzelheiten zu diesem Anhang : siehe Amtsblatt des Europäischen Patentamts, Nr.12/82